(19)

**Europäisches Patentamt**
**European Patent Office**
**Office européen des brevets**

(11) **EP 4 645 439 A1**

(12) **EUROPEAN PATENT APPLICATION**

(43) Date of publication:
**05.11.2025 Bulletin 2025/45**

(21) Application number: **25173484.4**

(22) Date of filing: **30.04.2025**

(51) International Patent Classification (IPC):
$H01M\ 4/133^{(2010.01)}$    $H01M\ 4/134^{(2010.01)}$
$H01M\ 4/36^{(2006.01)}$    $H01M\ 4/38^{(2006.01)}$
$H01M\ 4/587^{(2010.01)}$    $H01M\ 10/0525^{(2010.01)}$
$H01M\ 4/02^{(2006.01)}$

(52) Cooperative Patent Classification (CPC):
**H01M 4/386; H01M 4/133; H01M 4/134;**
**H01M 4/364; H01M 4/587; H01M 10/0525;**
H01M 2004/027; Y02E 60/10

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **30.04.2024 CN 202410543445**

(71) Applicant: **Ningde Amperex Technology Ltd.**
**Ningde City, Fujian Province 352100 (CN)**

(72) Inventor: **LI, Liang**
**Ningde City, Fujian Province, China, 352100 (CN)**

(74) Representative: **Icosa**
**83 avenue Denfert-Rochereau**
**75014 Paris (FR)**

(54) **SILICON-CARBON COMPOSITE MATERIAL, NEGATIVE ELECTRODE PLATE, SECONDARY BATTERY, AND ELECTRONIC DEVICE**

(57)    A silicon-carbon composite material includes a porous carbon skeleton and pores of the porous carbon skeleton contain a silicon material. The porous carbon skeleton satisfies: $1.5 < (c-a)/b < 5.0$, where a represents a pore diameter corresponding to a cumulative pore volume percentage accounting for 10% of a total pore volume, b represents a pore diameter corresponding to a cumulative pore volume percentage accounting for 50% of the total pore volume, and c represents a pore diameter corresponding to a cumulative pore volume percentage 99% in the total pore volume. The technical solution of this application improves the cycle performance and high-temperature performance of the secondary battery while achieving a high energy density of the secondary battery.

EP 4 645 439 A1

**Description**

## TECHNICAL FIELD

This application relates to the field of battery technology, and in particular, to a silicon-carbon composite material, a negative electrode plate, a secondary battery, and an electronic device.

## BACKGROUND

As a negative electrode material of a lithium-ion battery, silicon possesses a theoretical gravimetric capacity of up to 4200 mAh/g, and is considered to be the negative electrode material that is most likely to replace conventional graphite. However, during charging and discharging of silicon particles, the process of intercalation of lithium ions gives rise to a phase change, and in turn, brings severe volume expansion of particles. For a silicon-carbon composite obtained by a conventional sand-milling method, the expansion of silicon is still inevitable. Currently, depositing a silicon-carbon material by a silane method has become a mainstream direction of silicon material development. The silane method provides an effective solution to the silicon expansion problem through a reserved-hole design. However, due to complexity of the silane deposition process, the structure of the reserved holes forms many invalid holes. The invalid holes are of relatively low strength. During a cold-pressing process, the particles are prone to be fractured and crushed, and then to contact and react with an electrolyte solution, thereby deteriorating the cycle performance and expansion performance of the battery.

## SUMMARY

In view of the above situation, this application provides a silicon-carbon composite material, a negative electrode plate, a secondary battery, and an electronic device. The technical solution of this application improves the cycle performance and high-temperature performance of the secondary battery while achieving a high energy density of the secondary battery.

According to a first aspect, this application provides a silicon-carbon composite material. The silicon-carbon composite material includes a porous carbon skeleton and pores of the porous carbon skeleton contain a silicon material. The silicon material can increase the energy density of a battery. The porous carbon skeleton satisfies: $1.5 < (c - a)/b < 5.0$ (in this application, $d = (c - a)/b$), where $a$ represents a pore diameter corresponding to a cumulative pore volume percentage accounting for 10% of a total pore volume, $b$ represents a pore diameter corresponding to a cumulative pore volume percentage accounting for 50% of the total pore volume, $c$ represents a pore diameter corresponding to a cumulative pore volume percentage accounting for 99% of the total pore volume, and $a$, $b$, and $c$ are all measured in units of nm. The $(c-a)/b$ ratio can represent the pore size distribution concentration of the porous carbon skeleton (that is, a ratio of a difference between the macropore percentage and the micropore percentage to the mesopore percentage). The smaller the ratio, the closer the size of macropores is to the size of micropores, and the higher the degree of concentration of the pore distribution. By controlling the $(c-a)/b$ ratio to fall within the above range, this application enables the degree of concentration of the pore structure of the porous carbon skeleton to be relatively high. After the porous carbon skeleton is placed in a deposition reactor to uniformly deposit silane, the overall structural strength of the material is higher, and the material is more pressure-resistant, thereby improving the cycle performance and high-temperature performance of a lithium-ion battery. Preferably, $0.8 \text{ nm} < a < 1.5 \text{ nm}$, $1.8 \text{ nm} < b < 3.0 \text{ nm}$, and $5.0 \text{ nm} < c < 10.0 \text{ nm}$.

In some embodiments, $2.0 \leq (c - a)/b \leq 2.9$. This setting further improves the structural strength of the porous carbon skeleton, improves the pressure resistance of the silicon-carbon composite material, and in turn, improves the cycle performance and high-temperature performance of the lithium-ion battery while achieving a relatively high energy density at the same time. Specifically, in some examples, $2.0 \leq (c - a)/b \leq 2.7$. In some examples, $2.0 \leq (c - a)/b \leq 2.5$. In some examples, $2.0 \leq (c - a)/b \leq 2.4$. In some examples, $2.0 \leq (c - a)/b \leq 2.3$.

In some embodiments, $1.1 \text{ nm} \leq a \leq 1.4 \text{ nm}$. When the value of $a$ falls within the above range, $a$ can coordinate with $b$ and $c$ to more favorably improve the compressive strength of the silicon-carbon composite material. Specifically, in some examples, $1.1 \text{ nm} \leq a \leq 1.3 \text{ nm}$. In some examples, $1.1 \text{ nm} \leq a \leq 1.2 \text{ nm}$.

In some embodiments, $2.2 \text{ nm} \leq b \leq 2.7 \text{ nm}$. When the value of $b$ falls within the above range, $b$ can coordinate with $a$ and $c$ to more favorably improve the pressure resistance of the silicon-carbon composite material. Specifically, in some examples, $2.3 \text{ nm} \leq b \leq 2.7 \text{ nm}$. In some examples, $2.4 \text{ nm} \leq b \leq 2.7 \text{ nm}$. In some examples, $2.5 \text{ nm} \leq b \leq 2.7 \text{ nm}$. In some examples, $2.6 \text{ nm} \leq b \leq 2.7 \text{ nm}$.

In some embodiments, $5.7 \text{ nm} \leq c \leq 6.5 \text{ nm}$. When the value of $c$ falls within the above range, $c$ can coordinate with $a$ and $b$ to increase the overall structural strength of the material. Specifically, in some examples, $5.9 \text{ nm} \leq c \leq 6.5 \text{ nm}$. In some examples, $6.1 \text{ nm} \leq c \leq 6.5 \text{ nm}$. In some examples, $6.3 \text{ nm} \leq c \leq 6.5 \text{ nm}$. In some examples, $6.4 \text{ nm} \leq c \leq 6.5 \text{ nm}$.

In some embodiments, the silicon material includes a silicon-carbon material and/or a silicon-oxygen material.

In some embodiments, the porous carbon skeleton includes a phenolic resin-based porous carbon skeleton. To be specific, the porous carbon skeleton is polymerized from a phenolic monomer (with a purity higher than 99.9%), with a degree of curing greater than 97.0%. The porous carbon skeleton contains ultramicropores. Based on the total pore volume E cc/g of the porous carbon skeleton, the pore volume percentage of the ultramicropores is e%, satisfying: E > 0.55, and e<9.0, and preferably, $0.75 \leq E \leq 0.85$, and $e \leq 4.0$. The pore diameter of the ultramicropores is less than 0.7 nm. By controlling the pore volume percentage of ultramicropores (< 0.7 nm) to fall within the above range, this application avoids pore blocking during silane deposition, thereby avoiding the formation of invalid pores inside the porous carbon skeleton, further improving the compressive strength of the silicon-carbon composite material, and achieving a silicon-carbon material of a relatively high compressive resistance. In this way, the particles are prevented from being crumbled even when the compacted density of an electrode plate is very high (for example, compacted density > 1.74 g/cc), thereby giving full play to the advantage of a high volumetric energy density of the silicon material. In addition, invalid pores are effectively reduced, and the mixing ratio between the micropores and the deposited silicon in the material is more reasonable, thereby achieving relatively high performance of half-charge rebound and expansion, and in turn, improving the cycle performance and high-temperature performance of the lithium-ion battery.

A method for preparing the phenolic resin-based porous carbon is optionally, but not limited to: using phenol and formaldehyde as monomers, performing catalysis by using one or more composite catalysts selected from hydrochloric acid, ammonia water, sodium hydroxide, or triethylamine, and then adding a dispersant and a curing agent.

In some embodiments, the porous carbon skeleton (phenolic resin-based porous carbon skeleton) is obtained by activating phenolic resin-based porous carbon through an alkaline medium. Conditions of the activation include: an activation temperature being 750 °C to 800 °C, an activation time being 3 h to 3.5 h, and an alkali-carbon ratio being 3 to 3.5. In this way, by controlling the activation temperature, the activation time, and the alkali-carbon ratio in a synergistic manner, this application can control the value of the (c-a)/b ratio to fall within the range specified herein. Further, the pore volume percentage e% of the ultramicropores is controlled to fall within a suitable range.

In some embodiments, after the silicon-carbon composite material is compressed at a pressure of 295.33 MPa for 30 seconds, a specific surface area (BET) of the silicon-carbon composite material is f m²/g, satisfying: 2.0 < f < 5.0. In addition, after being compressed at a pressure of 295.33 MPa for 30 seconds, a compacted density of the silicon-carbon composite material is n g/cc, satisfying: 0.95 g/cc < n < 1.10 g/cc. As can be seen, the silicon-carbon composite material of this application exhibits a relatively high compressive strength, thereby improving the cycle performance and high-temperature performance of the lithium-ion battery.

According to a second aspect, this application provides a negative electrode plate. The negative electrode plate includes a negative current collector and a negative electrode material layer disposed on at least one surface of the negative current collector. The negative electrode material layer includes a negative electrode material. The negative electrode material includes any one of the silicon-carbon composite materials according to the first aspect described above.

In some embodiments, when the negative electrode material includes the silicon-carbon composite material (in which the mass percent of silicon is 35% to 55%) with an amount less than 10 wt%, a compacted density of the negative electrode material layer is greater than 1.74 g/cc. As can be seen, the particles of the silicon-carbon composite material of this application are not prone to crumble even when the compacted density of the electrode plate is very high, thereby giving full play to the advantages of a high volumetric energy density of the silicon-carbon composite material, and also improving the cycle performance and high-temperature performance of the lithium-ion battery at the same time.

In some embodiments, after the negative electrode plate is cold-pressed, the compacted density when the particles of the silicon-carbon composite material in the negative electrode plate are ruptured is m g/cc, satisfying: m > 1.80. Conditions of the cold pressing include: a cold-pressing pressure being 100 MPa to 500 MPa, the cold-pressing temperature being 20 °C to 28 °C, and the cold-pressing time being 10 to 60 hours. By controlling the pore size distribution of the porous carbon precursor and the proportion of the particles of each different pore diameter, this application can effectively improve the compressive resistance of the silicon-carbon composite material, increase the compacted density of the silicon-carbon composite material, and improve the cycle performance and high-temperature performance of the lithium-ion battery.

According to a third aspect, this application provides a method for preparing the silicon-carbon composite material. The method includes following steps: (1) obtaining carbonized porous carbon, activating the porous carbon with an alkaline medium at 750 °C to 800 °C for 1.5 h to 2 h, at an alkali-carbon ratio of 3 to 3.5, to obtain a porous carbon skeleton; (2) placing the porous carbon skeleton into a deposition reactor to undergo a first-stage deposition and a second-stage deposition, where the first-stage deposition is to pass a silane gas into the reactor at a volume percent of 1% to 100% at a temperature of 520 °C to 600 °C, all remaining constituents are an inert gas, and the deposition continues for a deposition time of 2 h to 8 h; the second-stage deposition is to pass a silane gas into the reactor at a volume percent of 1% to 100% at a temperature of 470 °C to 520 °C, all remaining constituents are an inert gas, and the deposition continues for a deposition time of 15 h to 30 h; and (3) passing a pure inert gas into the reactor for 60 minutes after completion of the deposition reaction, and then passing an acetylene gas into the reactor at a concentration of 5% to 100%, and continuing the deposition at 450 °C to 520 °C for 1 to 48 hours.

According to a fourth aspect, this application provides a secondary battery. The secondary battery includes any one of the negative electrode plates according to the second aspect described above; or, the secondary battery includes any one of the silicon-carbon composite materials according to the first aspect described above; or, the secondary battery includes a silicon-carbon composite material, and the silicon-carbon composite material is prepared by the method according to the third aspect described above.

According to a fifth aspect, this application provides an electronic device. The electronic device includes any one of the secondary batteries according to the fourth aspect.

## DETAILED DESCRIPTION

To make the objectives, technical solutions, and advantages of this application clearer, the following describes this application in more detail with reference to embodiments. Understandably, the specific embodiments described herein are merely intended to explain this application, but are not intended to limit this application.

A relatively high energy density and a relatively high expansion rate of a silicon-based material is a main bottleneck of massive industrialization thereof. In actual mass production and research, a main technical solution in the industry is to provide space for the release and buffering of silicon expansion stress through specialized structural design of the silicon-based material. Initially, micron silicon is adjusted to nano silicon to avoid pulverization caused by a stress difference between different locations of silicon particles during charge-and-discharge cycles. In addition, the nano silicon is mixed with graphite, pitch, and other organic carbon sources to obtain buffer space and reliable electrical contact. However, in this structure, the expansion of silicon inevitably breaks the buffer layer, and in turn, causes contact between silicon and an electrolyte solution and gives rise to recurrent formation of a solid electrolyte interface film, thereby impairing the electrical performance of the secondary battery. To obtain a more stable structure, some researchers deposit silane in porous carbon of a microporous-mesoporous structure, and obtains silicon expansion space through a reserved pore structure, thereby achieving good electrical properties. However, the reserved pore structure is prone to cause particle rupture during cold-pressing due to the complexity of the carbon activation and silane deposition processes. The ruptured particles recurrently form a solid electrolyte interface film in a full cell, and disrupt the improvement of the compacted density of the electrode plate, thereby severely reducing the energy density of the secondary battery. To effectively solve this problem, this application provides a silicon-carbon composite material, a negative electrode plate, a secondary battery, and an electronic device. By controlling the process of carbon activation and pore formation, on the one hand, this application forms a pore structure of a high degree of concentration, so that the overall structural strength of the material is higher after uniform deposition of silane. On the other hand, the volume of ultramicropores is specially controlled to avoid pore blockage during the silane deposition, thereby avoiding the formation of internal invalid pores that reduce the compressive resistance. Finally, the material achieves relatively high compressive strength, and the compressive resistance of the resultant silicon-carbon material is relatively high. The particles are prevented from crumbling even when the compacted density of the electrode plate is very high, thereby giving full play to the advantages of a high volumetric energy density of the silicon-carbon composite material. In addition, the invalid pores are effectively reduced, so that the material exhibits relatively high half-charge rebound and expansion performance.

### Silicon-carbon composite material

A first aspect of some embodiments of this application provides a silicon-carbon composite material. The silicon-carbon composite material includes a porous carbon skeleton and pores of the porous carbon skeleton contain a silicon material. The porous carbon skeleton satisfies: $1.5 < (c - a)/b < 5.0$, where a represents a pore diameter corresponding to a cumulative pore volume percentage accounting for 10% of a total pore volume, b represents a pore diameter corresponding to a cumulative pore volume percentage accounting for 50% of the total pore volume, c represents a pore diameter corresponding to a cumulative pore volume percentage 99% in the total pore volume, and a, b, and c are all measured in units of nm. By controlling the (c-a)/b ratio to fall within the above range, this application enables the degree of concentration of the pore structure of the porous carbon skeleton to be relatively high. After the porous carbon skeleton is placed in a deposition reactor to uniformly deposit silane, the overall structural strength of the material is higher, and the material is more pressure-resistant, thereby improving the cycle performance and high-temperature performance of a lithium-ion battery. As an example, the (c-a)/b ratio is 1.5, 1.6, 1.8, 2.0, 2.1, 2.3, 2.4, 2.5, 2.6, 2.7, 2.8, 2.9, 3.0, 3.3, 3.5, 4.0, 4.2, 4.5, 4.9, 4.99, or a value falling within a range formed by any two thereof.

In some embodiments, $0.8 \text{ nm} < a < 1.5 \text{ nm}$. When the value of a falls within the above range, a can coordinate with b and c to more favorably improve the compressive strength of the silicon-carbon composite material. As an example, the value range of a is 0.81 nm, 0.85 nm, 0.9 nm, 1.0 nm, 1.1 nm, 1.2 nm, 1.3 nm, 1.4 nm, 1.41 nm, 1.43 nm, 1.45 nm, 1.49 nm, or a value falling within a range formed by any two thereof.

In some embodiments, $1.8 \text{ nm} < b < 3.0 \text{ nm}$. When the value of b falls within the above range, b can coordinate with a and c to more favorably improve the pressure resistance of the silicon-carbon composite material. As an example, the value of b is 1.81 nm, 1.9 nm, 2.0 nm, 2.2 nm, 2.3 nm, 2.5 nm, 2.6 nm, 2.7 nm, 2.8 nm, 2.9 nm, 2.99 nm, or a value falling within a range formed by any two thereof.

In some embodiments, 5.0 nm < c < 10.0 nm. When the value of c falls within the above range, c can coordinate with a and b to increase the overall structural strength of the material. As an example, the value of c is 5.1 nm, 5.3 nm, 5.5 nm, 5.7 nm, 6.0 nm, 6.2 nm, 6.3 nm, 6.5 nm, 7.0 nm, 8.5 nm, 9.0 nm, 9.5 nm, 9.9 nm, or a value falling within a range formed by any two thereof.

In some embodiments, the silicon material includes a silicon-carbon material and/or a silicon-oxygen material.

In some embodiments, the porous carbon skeleton includes a phenolic resin-based porous carbon skeleton. The porous carbon skeleton contains ultramicropores. Based on the total pore volume E cc/g of the porous carbon skeleton, the pore volume percentage of the ultramicropores is e%, satisfying: E > 0.55, and e<9.0, and preferably, $0.75 \leq E \leq 0.85$, and e $\leq 4.0$. The pore diameter of the ultramicropores is less than 0.7 nm. By controlling the pore volume percentage of ultramicropores (< 0.7 nm) to fall within the above range, this application avoids pore blocking during silane deposition, thereby avoiding the formation of invalid pores inside the porous carbon skeleton, further improving the compressive strength of the silicon-carbon composite material, achieving a silicon-carbon material of a relatively high compressive resistance, and improving the cycle performance and high-temperature performance of the lithium-ion battery more effectively. As an example, the total pore volume E of the porous carbon skeleton is 0.6 cc/g, 0.65 cc/g, 0.7 cc/g, 0.75 cc/g, 0.78 cc/g, 0.80 cc/g, 0.82 cc/g, 0.83 cc/g, 0.85 cc/g, 0.9 cc/g, or a value falling within a range formed by any two thereof. As an example, the pore volume percentage of the ultramicropores is 0.01%, 0.1%, 0.5%, 0.8%, 1.0%, 1.5%, 2.0%, 2.5%, 3.0%, 3.5%, 4.0%, 6.5%, 7.0%, 8.5%, 8.9%, or a value falling within a range formed by any two thereof. As an example, the pore diameter of the ultramicropores is 0.01 nm, 0.1 nm, 0.3 nm, 0.4 nm, 0.5 nm, 0.6 nm, 0.65 nm, 0.69 nm, or a value falling within a range formed by any two thereof.

In some embodiments, the phenolic resin-based porous carbon skeleton is obtained by activating phenolic resin-based porous carbon through an alkaline medium. Conditions of the activation include: an activation temperature being 750 °C to 800 °C, an activation time being 3 h to 3.5 h, and an alkali-carbon ratio being 3 to 3.5. As an example, the activation temperature is 750 °C, 760 °C, 770 °C, 780 °C, 790 °C, 800 °C, or a value falling within a range formed by any two thereof. As an example, the activation time is 3 h, 3.1 h, 3.2 h, 3.3 h, 3.4 h, 3.5 h, or a value falling within a range formed by any two thereof. As an example, the alkali-carbon ratio is 3, 3.1, 3.2, 3.3, 3.4, 3.5, or a value falling within a range formed by any two thereof.

In some embodiments, after the silicon-carbon composite material is compressed at a pressure of 295.33 MPa for 30 seconds, the BET specific surface area of the silicon-carbon composite material is f m$^2$/g, satisfying: 2.0 < f < 5.0. As can be seen, the silicon-carbon composite material of this application exhibits a relatively high compressive strength, thereby improving the cycle performance and high-temperature performance of the lithium-ion battery. As an example, the BET specific surface area of the compressed silicon-carbon composite material is 2.05 m$^2$/g, 2.1 m$^2$/g, 2.3 m$^2$/g, 2.8 m$^2$/g, 3.0 m$^2$/g, 3.5 m$^2$/g, 4.0 m$^2$/g, 4.5 m$^2$/g, 4.8 m$^2$/g, 4.9 m$^2$/g, 4.95 m$^2$/g, or a value falling within a range formed by any two thereof.

In some embodiments, after the silicon-carbon composite material is compressed at a pressure of 295.33 MPa for 30 seconds, the compacted density of the silicon-carbon composite material is n g/cc, satisfying: 0.95 < n < 1.10. As can be seen, the silicon-carbon composite material of this application exhibits a relatively high compressive strength, thereby improving the cycle performance and high-temperature performance of the lithium-ion battery. As an example, the compacted density after compression is 0.96 g/cc, 0.98 g/cc, 1.0 g/cc, 1.05 g/cc, 1.08 g/cc, 1.10 g/cc, or a value falling within a range formed by any two thereof.

In some embodiments, after the negative electrode plate is cold-pressed, the compacted density when the particles of the silicon-carbon composite material in the negative electrode plate are ruptured is m g/cc, satisfying: m > 1.80. Conditions of the cold pressing include: a cold-pressing pressure being 100 MPa to 500 MPa, the cold-pressing temperature being 20 °C to 28 °C, and the cold-pressing time being 10 to 60 hours. By controlling the pore size distribution of the porous carbon precursor and the proportion of the particles of each different pore diameter, this application can effectively improve the compressive resistance of the silicon-carbon composite material, increase the compacted density of the silicon-carbon composite material, and improve the cycle performance and high-temperature performance of the lithium-ion battery.

**Method for preparing a silicon-carbon composite material**

(1) Obtaining carbonized porous carbon, activating the porous carbon with an alkaline medium at 750 °C to 800 °C for 1.5 h to 2 h, at an alkali-carbon ratio of 3 to 3.5, to obtain a porous carbon skeleton.
(2) Placing the porous carbon skeleton into a deposition reactor to undergo a first-stage deposition and a second-stage deposition, where the first-stage deposition is to pass a silane gas into the reactor at a volume percent of 1% to 100% at a temperature of 520 °C to 600 °C, all remaining constituents are an inert gas, and the deposition continues for a deposition time of 2 h to 8 h.

The second-stage deposition is to pass a silane gas into the reactor at a volume percent of 1% to 100% at a temperature of 470 °C to 520 °C, all remaining constituents are an inert gas, and the deposition continues for a deposition time of 15 h to 30 h.

(3) Passing a pure inert gas into the reactor for 60 minutes after completion of the deposition reaction, and then passing an acetylene gas into the reactor at a concentration of 5% to 100%, and continuing the deposition at 450 °C to 520 °C for 1 to 48 hours.

**Negative electrode plate**

A second aspect of some embodiments of this application provides a negative electrode plate. The negative electrode plate includes a negative current collector and a negative electrode material layer disposed on at least one surface of the negative current collector. The negative electrode material layer includes a negative electrode material. The negative electrode material includes any one of the silicon-carbon composite materials according to the first aspect described above and a carbon material. The carbon material includes, but is not limited to, at least one of natural graphite, artificial graphite, mesocarbon microbeads, hard carbon, or soft carbon. The mass ratio of the silicon-carbon composite material to the carbon material is approximately 9 : 1. When the negative electrode material includes the silicon-carbon composite material with an amount less than 10 wt%, the compacted density of the negative electrode material layer is greater than 1.74 g/cc.

The thickness of the negative electrode material layer is not particularly limited herein, as long as the objectives of this application can be achieved. For example, the thickness of the negative active layer is 30 $\mu$m to 120 $\mu$m. The negative current collector is not particularly limited herein, as long as the objectives of this application can be achieved. For example, the negative current collector may include copper foil, copper alloy foil, nickel foil, stainless steel foil, titanium foil, foamed nickel, foamed copper, or a composite current collector (for example, a composite current collector formed by a metal-clad polymer), or the like. The thickness of the negative current collector is not particularly limited herein, as long as the objectives of this application can be achieved. For example, the thickness of the negative current collector is 5 $\mu$m to 12 $\mu$m. The negative electrode material layer may further include a binder and a thickener. The types of the binder and thickener are not particularly limited herein, as long as the objectives of this application can be achieved. For example, the binder may include, but is not limited, to at least one of polyvinyl alcohol, polyvinyl chloride, carboxylated polyvinyl chloride, polyvinyl fluoride, polyvinylpyrrolidone, polyurethane, polytetrafluoroethylene, polyvinylidene difluoride, styrene-butadiene rubber, or acrylated styrene-butadiene rubber. The thickener may include, but is not limited to, at least one of sodium carboxymethyl cellulose or lithium carboxymethyl cellulose. In addition, the negative electrode material layer may include a conductive agent. The type of the conductive agent is not particularly limited herein, as long as the objectives of this application can be achieved. For example, the conductive agent may include, but is not limited to, at least one of conductive carbon black, carbon nanotubes (CNTs), carbon fibers, Ketjen black, graphene, a metal material, or a conductive polymer. The mass ratio between the negative electrode material, the conductive agent, the binder, and the thickener in the negative electrode material layer is not particularly limited herein, and may be selected by a person skilled in the art as actually required, as long as the objectives of this application can be achieved. Optionally, the negative electrode plate may further include a conductive layer. The conductive layer is located between the negative current collector and the negative active layer. The constituents of the conductive layer are not particularly limited herein, and the conductive layer may be a conductive layer commonly used in the art. For example, the conductive layer includes a conductive agent and a binder. The conductive agent and binder in the conductive layer are not particularly limited herein. For example, the conductive agent and binder may be at least one of the conductive agents and binders in the negative active layer enumerated above.

**Secondary battery**

A third aspect of some embodiments of this application provides a secondary battery. The secondary battery includes a positive electrode plate, a negative electrode plate, a separator, and an electrolyte solution. The separator is disposed between the positive electrode plate and the negative electrode plate. The negative electrode plate is any one of the negative electrode plates according to the second aspect.

According to some embodiments of this application, the secondary battery according to this application includes, but is not limited to: a lithium-ion battery or a sodium-ion battery. In some embodiments, the secondary battery is a lithium-ion battery.

**Other components**

The positive electrode plate includes a positive current collector and a positive electrode material layer disposed on at least one surface of the positive current collector. The positive current collector is not particularly limited herein, as long as the objectives of this application can be achieved. For example, the positive current collector may include aluminum foil, aluminum alloy foil, a composite current collector (for example, a composite current collector formed by a metal-clad polymer), or the like. The thickness of the positive current collector is not particularly limited in this application, as long as the objectives of this application can be achieved. For example, the thickness of the positive current collector is 5 $\mu$m to 13 $\mu$m. The positive electrode material layer includes a positive active material. The positive active material is not particularly limited herein as long as the objectives of this application can be achieved. For example, the positive active material may include, but is not limited to, at least one of lithium nickel cobalt manganese oxide (for example, typically NCM811, NCM622, NCM523, NCM111), lithium nickel cobalt aluminum oxide, lithium iron phosphate, a lithium-rich manganese-based material, lithium cobalt oxide, lithium manganese oxide, or lithium manganese iron phosphate. In addition, the positive electrode material layer may include a conductive agent and a binder. The types of the conductive agent and the binder are not particularly limited herein, as long as the objectives of this application can be achieved. For example, the conductive agent may include, but is not limited to, at least one of conductive carbon black, carbon nanotubes (CNTs), carbon fibers, Ketjen black, graphene, a metal material, or a conductive polymer. The metal material may include, but is not limited to, metal powder and/or metal fibers. Specifically, the metal may include, but is not limited to, at least one of copper, nickel, aluminum, or silver. The conductive polymer may include, but is not limited to, at least one of polyphenylene derivatives, polyaniline, polythiophene, polyacetylene, or polypyrrole. The binder may include, but is not limited to, at least one of polyacrylic acid, polyacrylate, an acrylate polymer, polyvinyl alcohol, polyvinylidene difluoride, polytetrafluoroethylene, or poly(vinylidene fluoride-co-hexafluoropropylene). The mass percentages of the positive active material, the conductive agent, and the binder in the positive electrode material layer are not particularly limited herein, and may be selected by a person skilled in the art as actually needed, as long as the objectives of this application can be achieved.

The separator may include a substrate layer and a surface treatment layer. The substrate layer may be a non-woven fabric, film or composite film, which, in each case, is porous. The material of the substrate layer may include at least one of polyethylene, polypropylene, polyethylene terephthalate, or polyimide. Optionally, the surface treatment layer is disposed on at least one surface of the substrate layer. The surface treatment layer may be a bonding layer or a heat-resistant layer. For example, the bonding layer includes a binder. The material of the binder includes at least one of polyamide, polyacrylonitrile, acrylate polymer, polyacrylic acid, polyacrylate, polyvinylpyrrolidone, polyvinyl ether, polyvinylidene difluoride, or poly(vinylidene difluoride-co-hexafluoropropylene). The heat-resistant layer includes inorganic particles and a binder. The inorganic particles are not particularly limited, and, for example, may include at least one of aluminum oxide, silicon oxide, magnesium oxide, titanium oxide, hafnium dioxide, tin oxide, ceria, nickel oxide, zinc oxide, calcium oxide, zirconium oxide, yttrium oxide, silicon carbide, boehmite, aluminum hydroxide, magnesium hydroxide, calcium hydroxide, or barium sulfate. The binder is not particularly limited herein, and, for example, may be at least one of the binders in the above bonding layer.

The electrolyte solution includes an organic solvent, an electrolyte lithium salt, and an additive. The types thereof are not particularly limited herein, and may be selected according to actual needs.

As an example, the organic solvent may include one or more of, and preferably two or more of: ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethylene propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), methyl sulfonyl methane (MSM), ethyl methyl sulfone (EMS), or (ethylsulfonyl) ethane (ESE).

As an example, the electrolyte lithium salt includes one or more of lithium hexafluorophosphate (LiPF$_6$), lithium tetrafluoroborate (LiBF$_4$), lithium perchlorate (LiClO$_4$), lithium hexafluoroarsenate (LiAsF$_6$), lithium bis(fluorosulfonyl) imide (LiFSI), lithium bis(trifluoromethanesulfonyl)imide (LiTFSI), lithium trifluoromethanesulfonate (LiTFS), lithium difluoro(oxalato)borate (LiDFOB), LiBOB (lithium bis(oxalato)borate), LiPO2F$_2$ (lithium difluorophosphate), lithium difluoro(bisoxalato)phosphate (LiDFOP), or lithium tetrafluoro(oxalato)phosphate (LiTFOP).

Optionally, the electrolyte solution further includes an additive. The type of the additive is not particularly limited herein, and may be any additive suitable for use in a lithium-ion battery and may be selected according to actual needs. As an example, the additive may be one or more of vinylene carbonate (VC), vinyl ethylene carbonate (VEC), fluoroethylene carbonate (FEC), 1,3-propane sultone (PS), succinonitrile (SN), adiponitrile (ADN), 1,3-propene sultone (PST), tris(trimethylsilane)phosphate (TMSP), or tris(trimethylsilane)borate (TMSB).

The secondary battery may be prepared by a conventional method in this field. An exemplary method is: Stacking the positive electrode plate, the separator, and the negative electrode plate in sequence in such a way that the separator is located between the positive electrode plate and the negative electrode plate to serve a function of separation, so as to obtain an electrode assembly, or, winding the above components to obtain an electrode assembly; and putting the electrode assembly into a packaging shell, injecting an electrolyte solution, and sealing the shell to obtain a secondary battery.

The structure of the lithium battery is not particularly limited, and may be a coin battery, a cylindrical battery, a prismatic battery, a pouch battery, or the like containing a single layer of separator or a plurality of layers of separators.

The uses of the lithium-ion battery of this application are not particularly limited, and the lithium-ion battery may be used in any electronic device known in the prior art. In some embodiments, the lithium-ion battery of this application is applicable to, but not limited to use in, a laptop computer, pen-inputting computer, mobile computer, e-book player, portable phone, portable fax machine, portable photocopier, portable printer, stereo headset, video recorder, liquid crystal display television set, handheld cleaner, portable CD player, mini CD-ROM, transceiver, electronic notepad, calculator, memory card, portable voice recorder, radio, backup power supply, motor, automobile, motorcycle, power-assisted bicycle, bicycle, lighting appliance, toy, game console, watch, electric tool, flashlight, camera, large household battery, lithium-ion capacitor, and the like.

Using a lithium-ion battery as an example, the following describes the implementations of this application in more detail with reference to specific embodiments and comparative embodiments. Unless otherwise specified, the parts, percentages, and ratios set forth herein are based on mass. Unless otherwise expressly specified, the reagents, materials, and instruments used herein are all commercially available.

**Embodiment 1-1**

(I) Preparing a lithium-ion battery

<Preparing a negative electrode plate>

Method for preparing a silicon-carbon composite material

1) Obtaining carbonized phenolic resin-based porous carbon (polymerized from phenol and formaldehyde at a carbonization temperature of 700 °C), activating the porous carbon by use of sodium hydroxide for an activation time of 1.7 hours at an activation temperature of 760 °C and at an alkali-carbon ratio of 3.2, so as to obtain a porous carbon skeleton (in which the total pore volume is 0.85 cc/g, and the pore volume percentage of ultramicropores is 6.0%).

2) Placing the porous carbon skeleton into a deposition reactor to undergo a first-stage deposition and a second-stage deposition, where the first-stage deposition is to pass a silane gas into the reactor at a volume percent of 50% at a temperature of 580 °C, all remaining constituents are an inert gas, and the deposition time is 5 h.

The second-stage deposition is to pass a silane gas into the reactor at a volume percent of 50% at a temperature of 510 °C, all remaining constituents are an inert gas, and the deposition time is 24 h.

3) Passing a pure inert gas into the reactor for 60 minutes after completion of the deposition reaction, and then passing an acetylene gas into the reactor at a concentration of 50%, and continuing the deposition at 600 °C for 10 hours to obtain a silicon-carbon composite material.

The preparation parameters for the silicon-carbon composite materials in Embodiment 1-2 to 1-12 and Comparative Embodiment 1 are set forth in Table 1-a, and other operations are the same as those in Embodiment 1-1. By adjusting the parameters in the preparation process, especially the activation temperature, activation time, and alkali-carbon ratio, this application can prepare porous carbon skeletons of different parameter values. The parameter values of the porous carbon skeletons in Embodiments 1-1 to 1-12 and Comparative Embodiment 1 are set forth in Table 1-b.

Artificial graphite added at a mass percent of 88.4%, the above-mentioned silicon-carbon composite material added at a mass percent of 9.8%, carbon nanotubes (CNT) added at a mass percent of 0.1% as a conductive agent, and polyacrylic acid (PAA) added at a mass percent of 1.7% as a binder are mixed at a solid mass ratio. Deionized water is added as a solvent and stirred well, so as to formulate a negative electrode slurry in which the solid content is 45 wt%. The negative electrode slurry is evenly applied onto one surface of negative current collector copper foil that is 6 $\mu$m thick. The copper foil is oven-dried at 85 °C for 4 hours to obtain a negative electrode plate coated with a negative electrode mixture layer on a single side. The negative electrode plate is cold-pressed (under a pressure of 20 tons), cut, and slit, and then dried in a vacuum at 120 °C for 12 hours to obtain a negative electrode plate of 76.6 mm × 875 mm in size.

<Preparing a positive electrode plate>

Mixing lithium cobalt oxide ($LiCoO_2$) as a positive active material, acetylene black as a positive conductive agent, and polyvinylidene difluoride (PVDF) as a positive binder at a mass ratio of 95: 2.5: 2.5, adding N-methyl-pyrrolidone (NMP) as a solvent, and stirring well to formulate a positive electrode slurry in which the solid content is 75 wt%. Coating one surface of a 9 µm-thick positive current collector aluminum foil with the positive electrode slurry evenly, and oven-drying the current collector at 85 °C to obtain a positive electrode plate coated with a positive electrode mixture layer on a single side. The positive electrode plate is cold-pressed (under a pressure of 20 tons), cut, and slit, and then dried in a vacuum at 85 °C for 4 hours to obtain a positive electrode plate of 74 mm × 867 mm in size.

<Preparing an electrolyte solution>

Adding $LiPF_6$ into a solvent in a dry argon atmosphere, where the solvent is a mixture of propylene carbonate (PC), ethylene carbonate (EC), and diethyl carbonate (DEC) (at a mass ratio of 1 : 1 : 1). Mixing well, and then adding fluoroethylene carbonate (FEC), and mixing well to obtain an electrolyte solution. The mass percent of $LiPF_6$ is 12.5%, and the mass percent of the FEC is 4.5%.

<Separator>

Using a 12 µm-thick porous polyethylene film (supplied by Celgard) as a separator.

<Preparing a lithium-ion battery>

Connecting the above-prepared positive electrode and negative electrode to tabs respectively, putting a separator between the positive electrode and the negative electrode, stacking the electrode plates and the separator together, and winding the stacked structure to obtain an electrode assembly. Subsequently, putting the electrode assembly together with an electrolyte solution into an aluminum laminated film packaging bag. Sealing the opening of the packaging bag by heat-sealing, and performing the steps such as chemical formation and capacity grading to make a lithium-ion battery. The lithium-ion battery is tested, and the test results are shown in Table 1-b.

(II) Test methods

  (1) The material being tested is compressed at a pressure of 295.33 MPa for 30 seconds and then a compacted density is measured as n g/cc.

Reference standard for the test: GB/T 24533-2009 *Graphite Negative Electrode Materials for Lithium-ion Batteries.* The test principles are: an amount of silicon-carbon composite material is weighed and added onto a specialized compaction die (of a known diameter). The die is hollow in the middle, and the upper part and the lower part of the die are metal discs respectively. The silicon-carbon composite material is placed between the metal discs. A round metal rod is placed on the top. The die is placed on a compacted density instrument. The pressure is set to the desired value. The thickness of the silicon-carbon composite material under the corresponding pressure is read on the instrument. The compacted density is calculated using the density formula $\rho = m/V$. The instrument model used in this test is SUNSTEST UTM7305, the pressure dwell time is 30 s, and the dwell time after pressure relief is 10 s. The compacted density is calculated according to the following formula: $n = m/V = m/(S \times H)$, where m represents the mass of the silicon-carbon composite material being tested, S represents the surface area of the die, and H is the height of the silicon-carbon composite material after pressure relief.

(2) The material is compressed at a pressure of 295.33 MPa for 30 seconds and then a specific surface area is measured as f $m^2/g$.

Reference standard for the test: GB/T 24533-2009 *Graphite Negative Electrode Materials for Lithium-ion Batteries.* The test principles are: an amount of silicon-carbon composite material is weighed and added onto a specialized compaction die (of a known diameter). The die is hollow in the middle, and the upper part and the lower part of the die are metal discs respectively. The silicon-carbon composite material is placed between the metal discs. A round metal rod is placed on the top. The die is placed on a compacted density instrument. The pressure is set to the desired value. The instrument model used in this test is SUNSTEST UTM7305, the pressure dwell time is 30 s, and the dwell time after pressure relief is 10 s. The compressed silicon-carbon composite material is taken out, and the specific surface area of the compressed silicon-carbon composite material is measured by using a specific surface area tester.

(3) Compacted density test for the electrode plate

A pressure is applied to the negative electrode plate, and then the thickness of the negative electrode plate is measured with a 0.1 µm resolution micrometer. At the same time, the negative electrode plate is cut into small discs of

1540.25 mm$^2$ in size, and the mass of the small discs is weighed. A plurality of small discs may be weighed together and then the measured values are weighted. The mass of the negative electrode plate net of the mass of the copper foil, divided by 2, is the mass of the negative electrode material layer on a single side. The compacted density of the electrode plate at this pressure is calculated according to $\rho = m_0/V$, where $m_0$ is the mass of one small disc of a 1540.25 mm$^2$ area containing the negative electrode material layer on a single side; and V is a product obtained by multiplying the thickness of the small disc of a 1540.25 mm$^2$ area by 1540.25 mm$^2$, where the thickness is the thickness of the negative electrode material layer on a single side obtained by dividing the thickness of the small disc net of the thickness of the current collector by 2. When the particles of the silicon-carbon composite material in the negative electrode plate are ruptured after the electrode plate is cold-pressed, the compacted density is measured in the same way as the above-mentioned test method for the compacted density of the electrode plate.

(4) Testing the pore volume and pore size distribution of porous carbon

The pore structure of a specimen is tested with a physical adsorption instrument (model: ipore 620) according to the following method: Placing 0.15 g of silicon-carbon composite material into a specimen tube, degassing the specimen at 200 °C for 6 h, and then testing the amount of adsorption of argon by the silicon-carbon composite material under different pressures; plotting an isothermal adsorption curve of the specimen, and then calculating the surface area, pore volume, and pore size distribution of the silicon-carbon composite material by means of BET and NLDFT fitting, so as to obtain a total pore volume E cc/g and a pore volume percentage e% of ultramicropores. In the pore volume and pore size distribution curve determined by NLDFT fitting, the pore diameters corresponding to the cumulative pore volume percentages 10%, 50%, and 99% in the total pore volume are a, b, and c, respectively.

(5) Testing the compacted density m g/cc when the particles of the silicon-carbon composite material in the electrode plate are ruptured

This compacted density test method is the same as the above-mentioned electrode plate compacted density test method except that a cross-section polishing (CP) test is performed in order to trace the occurrence of rupture of the silicon-carbon composite material in the electrode plate. Specifically, a rupture of a particle of the silicon-carbon composite material is determined if a crack of a longest diameter greater than 100 nm occurs on the particle of the silicon-carbon composite material at a magnification of 1000K of a ZEISS SEM (Sigma-02-33) (0.1-30KV) instrument in a backscatter mode (the longest diameter means a longest distance between two points on the edge of the crack). The electrode plate compacted density at this time is the minimum compacted density of the negative electrode plate in which the particles are ruptured.

(6) Testing the cycle performance

A battery is charged at a constant current of 0.7C at a temperature of 25 °C until the voltage reaches 4.4 V, and then charged at a constant voltage until the current drops to 0.025C. The battery is left to stand for 5 minutes, and then discharged at a current of 0.5C until the voltage drops to 3.0 V. The capacity obtained in the above step is used as an initial capacity. The battery is charged and discharged for several cycles. In each cycle, the battery is charged at 0.7C and then discharged at 0.5C, so as to obtain a capacity of the battery. The capacity obtained in each cycle is divided by the initial capacity to obtain a ratio. A capacity fading curve is plotted by using the ratios. When the capacity retention rate drops to 90% during the cycle test in a 25 °C environment, the number of cycles is recorded to characterize the room-temperature cycle performance of the lithium-ion battery. The thickness M of the lithium-ion battery charged to a 50% state of charge (SOC) (a half-charge state) for a second time is measured by using a parallel plate thickness gauge (with a load of 600 g). The battery is charged and discharged for 500 cycles according to the above charge-and-discharge process so that the lithium-ion battery reaches 100% SOC (a full-charge state). The thickness N of the lithium-ion battery at this time is measured again by using the parallel plate thickness gauge (with a load of 600 g). The expansion rate of the lithium-ion battery at the end of the 500th cycle tested at 25 °C is L= (N - M)/M × 100%. The thickness of the lithium-ion battery is measured under cold measurement conditions. In other words, the lithium-ion battery is taken back and measured in a normal-temperature test room.

The battery is charged at a constant current of 0.7C at a temperature of 45 °C until the voltage reaches 4.4 V, and then charged at a constant voltage until the current drops to 0.025C. The battery is left to stand for 5 minutes, and then discharged at a current of 0.5C until the voltage drops to 3.0 V. The capacity obtained in the above step is used as an initial capacity. The battery is charged and discharged for several cycles. In each cycle, the battery is charged at 0.7C and then discharged at 0.5C, so as to obtain a capacity of the battery. The capacity obtained in each cycle is divided by the initial capacity to obtain a ratio. A capacity fading curve is plotted by using the ratios. When the capacity retention rate drops to 80% during the cycle test in a 45 °C environment, the number of cycles is recorded to characterize the high-temperature cycle performance of the lithium-ion battery. The thickness P of the lithium-ion battery charged to 50% SoC (a half-charge state) for a second time is measured by using a parallel plate thickness gauge (with a load of 600 g). The battery is charged and discharged for 500 cycles according to the above charge-and-discharge process so that the lithium-ion battery reaches 100% SoC (a full-charge state). The thickness O of the lithium-ion battery at this time is measured again by using the parallel plate thickness gauge (with a load of 600 g). The expansion rate of the lithium-ion battery at the end of the $500^{th}$ cycle tested at 45 °C is Q = (O - P)/P $\times$ 100%. The thickness of the lithium-ion battery is measured under cold measurement conditions. In other words, the lithium-ion battery is taken back and measured in a normal-temperature test room.

(7) Method for determining the expansion rate of the lithium-ion battery stored for 24 hours at 70 °C

Preconditioning CAP-1 process: 1) The test temperature is 25 °C; 2) the battery is left to stand for 5 min; 3) the battery is charged at a constant current of 0.2C until the voltage reaches 3 V; 4) the battery is left to stand for 5 min; 5) the battery is charged at a constant current of 0.2C until the voltage reaches 4.53 V, and then charged at a constant voltage until the current drops to 0.02C. Test process: The thickness of the battery is measured under hot conditions by using a parallel plate gauge (PPG) under a load of 700 g, denoted as X; 6) the battery is left to stand for 5 min; 7) the test temperature is adjusted to 70 °C, and the battery is stored at this temperature for 24 hours, and then the thickness of the battery is measured under hot conditions by using the PPG under a load of 700 g, denoted as Y. The expansion rate of the lithium-ion battery stored for 24 hours at 70 °C is Z = (Y - X)/X $\times$ 100%.

(8) Thermal shock test method

Preconditioning-1 CAP process: 1) The test temperature is 20 °C ($\pm$5 °C); 2) the battery is left to stand for 5 min; 3) the battery is charged at a constant current of 0.7C until the voltage reaches 4.53 V, and then charged at a constant voltage until the current drops to 0.05C; 4) the battery is left to stand for 5 min. Test process: ① The appearance of the battery is checked and photographed before and after the test; ② A temperature sensing wire is affixed to a specified position; ③ a specimen is vertically placed in a box, heated to 135$\pm$2 °C at a rate of 5$\pm$2 °C, and kept for 60 min; ④ measurement frequency: the internal resistance of the battery is measured at a frequency of 1 KHz after pretreatment and test; ⑤ criteria: the specimen passes the test if neither fire nor explosion occurs. The temperature at which the lithium-ion battery catches fire or explodes is the lowest temperature of battery failure in the thermal shock test.

Compared with Embodiment 1-1, Embodiments 1-2 to 1-12 and Comparative Embodiment 1 are the same as Embodiment 1-1 except the different preparation parameters of the lithium-ion batteries set forth in Table 1-a. The test results of each embodiment and comparative embodiment are set forth in Table 1-b.

**Table 1-a (To be continued)**

| Embodiment | Activation temperature | Activation time | Alkali-carbon ratio | Total pore volume E | First-stage silane concentration | Duration of feeding silane at first stage (h) | Deposition temperature of silane at first stage (°C) |
|---|---|---|---|---|---|---|---|
| Comparative Embodiment 1 | 850 °C | 3.0h | 2.8 | 0.80 | 50% | 5 | 580 |
| Embodiment 1-1 | 760 °C | 1.7h | 3.2 | 0.85 | 50% | 5 | 580 |
| Embodiment 1-2 | 770 °C | 1.8h | 3.2 | 0.85 | 50% | 5 | 580 |
| Embodiment 1-3 | 780 °C | 1.8h | 3.2 | 0.85 | 50% | 5 | 580 |
| Embodiment 1-4 | 795 °C | 1.9h | 3.2 | 0.85 | 50% | 5 | 580 |
| Embodiment 1-5 | 770 °C | 1.6h | 3.1 | 0.85 | 50% | 5 | 580 |
| Embodiment 1-6 | 770 °C | 1.9h | 3.3 | 0.85 | 50% | 5 | 580 |

(continued)

| Embodiment | Activation temperature | Activation time | Alkali-carbon ratio | Total pore volume E | First-stage silane concentration | Duration of feeding silane at first stage (h) | Deposition temperature of silane at first stage (°C) |
|---|---|---|---|---|---|---|---|
| Embodiment 1-7 | 770 °C | 1.9h | 3.5 | 0.85 | 50% | 5 | 580 |
| Embodiment 1-8 | 760 °C | 1.8h | 3.1 | 0.85 | 50% | 5 | 580 |
| Embodiment 1-9 | 780 °C | 1.9h | 3.3 | 0.85 | 50% | 5 | 580 |
| Embodiment 1-10 | 785 °C | 1.8h | 3.4 | 0.85 | 50% | 5 | 580 |
| Embodiment 1-11 | 700 °C | 4.5h | 1.9 | 0.98 | 50% | 5 | 580 |
| Embodiment 1-12 | 700 °C | 0.5 h | 3.6 | 0.80 | 50% | 5 | 580 |

**Table 1-a (Continued)**

| Embodiment | Second-stage silane concentration | Duration of feeding silane at second stage (h) | Deposition temperature of silane at second stage (°C) | Acetylene concentration | Acetylene coating duration | Acetylene coating temperature (°C) |
|---|---|---|---|---|---|---|
| Comparative Embodiment 1 | 50% | 24 | 510 | 50% | 10h | 600 |
| Embodiment 1-1 | 50% | 24 | 510 | 50% | 10h | 600 |
| Embodiment 1-2 | 50% | 24 | 510 | 50% | 10h | 600 |
| Embodiment 1-3 | 50% | 24 | 510 | 50% | 10h | 600 |
| Embodiment 1-4 | 50% | 24 | 510 | 50% | 10h | 600 |
| Embodiment 1-5 | 50% | 24 | 510 | 50% | 10h | 600 |
| Embodiment 1-6 | 50% | 24 | 510 | 50% | 10h | 600 |
| Embodiment 1-7 | 50% | 24 | 510 | 50% | 10h | 600 |
| Embodiment 1-8 | 50% | 24 | 510 | 50% | 10h | 600 |
| Embodiment 1-9 | 50% | 24 | 510 | 50% | 10h | 600 |
| Embodiment 1-10 | 50% | 24 | 510 | 50% | 10h | 600 |
| Embodiment 1-11 | 50% | 24 | 510 | 50% | 10h | 600 |

(continued)

| Embodiment | Second-stage silane concentration | Duration of feeding silane at second stage (h) | Deposition temperature of silane at second stage (°C) | Acetylene concentration | Acetylene coating duration | Acetylene coating temperature (°C) |
|---|---|---|---|---|---|---|
| Embodiment 1-12 | 50% | 24 | 510 | 50% | 10h | 600 |

### Table 1-b (To be continued)

| Embodiment | a | b | c | d | f(m²/g) | n(g/cc) | m(g/cc) | Number of cycles counted when capacity retention rate of lithium-ion battery cycled at 25 °C drops to 90% |
|---|---|---|---|---|---|---|---|---|
| Embodiment 1-1 | 0.9 nm | 2.2 nm | 6.5 nm | 2.6 | 3.1 | 1.01 | 1.82 | 1002 |
| Embodiment 1-2 | 1.1 nm | 2.2 nm | 6.5 nm | 2.5 | 2.5 | 1.03 | 1.83 | 1057 |
| Embodiment 1-3 | 1.2 nm | 2.2 nm | 6.5 nm | 2.4 | 2.4 | 1.03 | 1.83 | 1089 |
| Embodiment 1-4 | 1.4 nm | 2.2 nm | 6.5 nm | 2.3 | 2.2 | 1.02 | 1.84 | 1129 |
| Embodiment 1-5 | 1.1 nm | 2.0 nm | 6.5 nm | 2.7 | 2.7 | 1.05 | 1.82 | 948 |
| Embodiment 1-6 | 1.1 nm | 2.5 nm | 6.5 nm | 2.2 | 2.4 | 1.02 | 1.84 | 1099 |
| Embodiment 1-7 | 1.1 nm | 2.7 nm | 6.5 nm | 2.0 | 2.1 | 1.00 | 1.85 | 1147 |
| Embodiment 1-8 | 1.1 nm | 2.2 nm | 5.7 nm | 2.1 | 3.0 | 1.01 | 1.85 | 1135 |
| Embodiment 1-9 | 1.1 nm | 2.2 nm | 7.5 nm | 2.9 | 2.3 | 1.02 | 1.81 | 889 |
| Embodiment 1-10 | 1.1 nm | 2.2 nm | 9.0 nm | 3.6 | 2.1 | 1.04 | 1.81 | 801 |
| Embodiment 1-11 | 0.3 nm | 2.2 nm | 6.5 nm | 2.8 | 6.1 | 1.12 | 1.78 | 467 |
| Embodiment 1-12 | 1.1 nm | 1.3 nm | 6.5 nm | 4.2 | 22.9 | 1.15 | 1.72 | 411 |
| Comparative Embodiment 1 | 1.1 nm | 2.2 nm | 15.0 nm | 6.3 | 45.4 | 1.20 | 1.68 | 378 |

### Table 1-b (Continued)

| Group | Expansion rate of lithium-ion battery cycled at 25 °C for 500 cycles | Number of cycles counted when capacity retention rate of lithium-ion battery cycled at 45 °C drops to 80% | Expansion rate of lithium-ion battery cycled at 45 °C for 500 cycles | Expansion rate of lithium-ion battery stored at 70 °C for 24 h | Lowest temperature of lithium-ion battery failure in thermal shock test |
|---|---|---|---|---|---|
| Embodiment 1-1 | 7.0% | 806 | 8.2% | 6.0% | 131 °C |
| Embodiment 1-2 | 6.8% | 899 | 7.8% | 5.0% | 132 °C |

(continued)

| Group | Expansion rate of lithium-ion battery cycled at 25 °C for 500 cycles | Number of cycles counted when capacity retention rate of lithium-ion battery cycled at 45 °C drops to 80% | Expansion rate of lithium-ion battery cycled at 45 °C for 500 cycles | Expansion rate of lithium-ion battery stored at 70 °C for 24 h | Lowest temperature of lithium-ion battery failure in thermal shock test |
|---|---|---|---|---|---|
| Embodiment 1-3 | 6.6% | 927 | 7.6% | 4.5% | 133 °C |
| Embodiment 1-4 | 6.4% | 955 | 7.4% | 4.0% | 134 °C |
| Embodiment 1-5 | 7.4% | 771 | 8.4% | 6.5% | 130 °C |
| Embodiment 1-6 | 6.6% | 934 | 7.5% | 4.3% | 133 °C |
| Embodiment 1-7 | 6.5% | 978 | 7.3% | 3.9% | 135 °C |
| Embodiment 1-8 | 6.6% | 966 | 7.4% | 4.6% | 134 °C |
| Embodiment 1-9 | 7.1% | 709 | 8.0% | 5.0% | 136 °C |
| Embodiment 1-10 | 7.9% | 621 | 9.1% | 6.9% | 130 °C |
| Embodiment 1-11 | 11.2% | 398 | 12.9% | 12.3% | 114 °C |
| Embodiment 1-12 | 12.8% | 303 | 14.5% | 13.7% | 110 °C |
| Comparative Embodiment 1 | 13.8% | 211 | 15.8% | 21.2% | 104 °C |
| Note: d = (c - a)/b represents the degree of concentration of pore size distribution of the porous carbon. | | | | | |

As can be seen from Table 1-a and Table 1-b, in the comparative embodiment versus the embodiment, the degree of concentration of the pore structure of the porous carbon skeleton in the embodiment is relatively high; the overall structural strength of the material is higher, and the material is more pressure-resistant; and the cycle performance and high-temperature performance of the lithium-ion battery are enhanced significantly. In the comparative embodiment, the degree of concentration in the pore size distribution of the porous carbon skeleton is not appropriate; and the cycle performance and high-temperature performance of the lithium-ion battery in the comparative embodiment are significantly lower than those in the embodiment.

Especially, when the porous carbon skeleton is further adjusted to satisfy 0.8 nm < a < 1.5 nm and 1.8 nm < b < 3.0 nm, the effect of improving the cycle performance and high-temperature performance of the lithium-ion battery is stronger.

Especially, when the silicon-carbon composite material satisfies 2.0 < f < 5.0 and 0.95 < n < 1.10 or m > 1.80, it indicates that the silicon-carbon composite material possesses relatively high compressive strength, and endows the lithium-ion battery with higher cycle performance and high-temperature performance.

In Embodiments 2-1 to 2-5, the activation parameters are further adjusted based on Embodiment 1-2 to change the pore volume percentage e% of ultramicropores. For specific operations, reference may be made to conventional technical means. The test results are shown in Table 2.

**Table 2 (To be continued)**

| Embodiment | e (%) | f (m$^2$/g) | n (g/cc) | m (g/cc) | Number of cycles counted when capacity retention rate of lithium-ion battery cycled at 25 °C drops to 90% |
|---|---|---|---|---|---|
| Embodiment 1-2 | 5.5 | 2.5 | 1.03 | 1.83 | 1057 |
| Embodiment 2-1 | 4.0 | 2.3 | 1.03 | 1.85 | 1100 |
| Embodiment 2-2 | 3.2 | 2.1 | 1.02 | 1.85 | 1132 |
| Embodiment 2-3 | 6.0 | 3.0 | 1.04 | 1.83 | 1044 |
| Embodiment 2-4 | 7.5 | 3.2 | 1.03 | 1.82 | 1009 |
| Embodiment 2-5 | 8.6 | 3.7 | 1.05 | 1.81 | 971 |

**Table 2 (Continued)**

| Embodiment | Expansion rate of lithium-ion battery cycled at 25 °C for 500 cycles | Number of cycles counted when capacity retention rate of lithium-ion battery cycled at 45 °C drops to 80% | Expansion rate of lithium-ion battery cycled at 45 °C for 500 cycles | Expansion rate of lithium-ion battery stored at 70 °C for 24 h | Lowest temperature of lithium-ion battery failure in thermal shock test |
|---|---|---|---|---|---|
| Embodiment 1-2 | 6.8% | 899 | 7.8% | 5.0% | 132 °C |
| Embodiment 2-1 | 6.5% | 945 | 7.5% | 4.0% | 135 °C |
| Embodiment 2-2 | 6.3% | 976 | 7.3% | 3.3% | 136 °C |
| Embodiment 2-3 | 6.9% | 856 | 7.9% | 5.2% | 132 °C |
| Embodiment 2-4 | 7.2% | 821 | 8.2% | 5.4% | 131 °C |
| Embodiment 2-5 | 7.4% | 798 | 8.5% | 5.7% | 131 °C |

As can be seen from Table 2, when the pore volume percentage e% of ultramicropores is less than 9.0%, the compressive strength of the silicon-carbon composite material is further improved, and the effect of improving the cycle performance and high-temperature performance of the lithium-ion battery is optimal.

**Claims**

1. A silicon-carbon composite material, **characterized in that**, comprising a porous carbon skeleton; pores of the porous carbon skeleton contain a silicon material; and

   the porous carbon skeleton satisfies: $1.5 < (c - a)/b < 5.0$,
   wherein, a represents a pore diameter corresponding to a cumulative pore volume percentage accounting for 10% of a total pore volume of the pores, b represents a pore diameter corresponding to a cumulative pore volume percentage accounting for 50% of the total pore volume of the pores, c represents a pore diameter corresponding to a cumulative pore volume percentage accounting for 99% of the total pore volume of the pores, and a, b and c are all measured in units of nm.

2. The silicon-carbon composite material according to claim 1, **characterized in that**, the porous carbon skeleton satisfies at least one of the following conditions:

   (1)

   $$0.8 \text{ nm} < a < 1.5 \text{ nm};$$

   (2)

   $$1.8 \text{ nm} < b < 3.0 \text{ nm};$$

   or
   (3)

   $$5.0 \text{ nm} < c < 10.0 \text{ nm}.$$

3. The silicon-carbon composite material according to claim 1 or 2, **characterized in that**, the porous carbon skeleton satisfies at least one of the following conditions:

   (1)

   $$1.1 \text{ nm} \leq a \leq 1.4 \text{ nm};$$

(2)

$$2.2 \text{ nm} \leq b \leq 2.7 \text{ nm};$$

or
(3)

$$5.7 \text{ nm} \leq c \leq 6.5 \text{ nm}.$$

4. The silicon-carbon composite material according to any one of claims 1 to 3, **characterized in that**, the porous carbon skeleton comprises a phenolic resin-based porous carbon skeleton, and the porous carbon skeleton further contains ultramicropores; and
based on the total pore volume E cc/g of the porous carbon skeleton, a pore volume percentage of the ultramicropores is e%, satisfying: E > 0.55, and e < 9.0.

5. The silicon-carbon composite material according to claim 4, **characterized in that**, $0.75 \leq E \leq 0.85$, and $e \leq 4.0$.

6. The silicon-carbon composite material according to claim 4 or 5, **characterized in that**, a pore diameter of each of the ultramicropores is less than 0.7 nm.

7. The silicon-carbon composite material according to any one of claims 1 to 6, **characterized in that**, after being compressed at a pressure of 295.33 MPa for 30 seconds, a specific surface area of the silicon-carbon composite material is f $m^2/g$, and 2.0 < f < 5.0.

8. The silicon-carbon composite material according to any one of claims 1 to 7, **characterized in that**, after being compressed at a pressure of 295.33 MPa for 30 seconds, a compacted density of the silicon-carbon composite material is n g/cc, and 0.95 < n < 1.10.

9. The silicon-carbon composite material according to any one of claims 1 to 8, **characterized in that**, the silicon material comprises a silicon-carbon material and/or a silicon-oxygen material.

10. The silicon-carbon composite material according to any one of claims 1 to 9, **characterized in that**, $2.0 \leq (c - a)/b \leq 2.9$.

11. A negative electrode plate, comprising a negative current collector and a negative electrode material layer disposed on at least one surface of the negative current collector; **characterized in that**, the negative electrode material layer comprises a negative electrode material, and the negative electrode material comprises the silicon-carbon composite material according to any one of claims 1 to 10.

12. The negative electrode plate according to claim 11, **characterized in that**, an amount of the silicon-carbon composite material in the negative electrode material is less than 10 wt%, and a compacted density of the negative electrode material layer is greater than 1.74 g/cc.

13. A method for preparing the silicon-carbon composite material according to any one of claims 1 to 10, **characterized in that**, the method comprises following steps:

(1) obtaining carbonized porous carbon, activating the porous carbon with an alkaline medium at 750 °C to 800 °C for 1.5 h to 2 h, at an alkali-carbon ratio of 3 to 3.5, to obtain a porous carbon skeleton;
(2) placing the porous carbon skeleton into a deposition reactor to undergo a first-stage deposition and a second-stage deposition, wherein the first-stage deposition is to pass a silane gas into the reactor at a volume percent of 1% to 100% at a temperature of 520 °C to 600 °C, all remaining constituents are an inert gas, and the first-stage deposition continues for a deposition time of 2 h to 8 h;
the second-stage deposition is to pass a silane gas into the reactor at a volume percent of 1% to 100% at a temperature of 470 °C to 520 °C, all remaining constituents are an inert gas, and the second-stage deposition continues for a deposition time of 15 h to 30 h; and
(3) passing a pure inert gas into the reactor for 60 minutes after completion of the first-stage deposition and the second-stage deposition, and then passing an acetylene gas into the reactor at a concentration of 5% to 100%, and continuing the deposition at 550 °C to 600 °C for 10 to 15 hours.

14. A secondary battery, **characterized in that**, the secondary battery comprises the negative electrode plate according to any one of claims 11 to 12.

15. An electronic device, **characterized in that**, the electronic device comprises the secondary battery according to claim 14.

Europäisches Patentamt
European Patent Office
Office européen des brevets

# EUROPEAN SEARCH REPORT

**Application Number**

EP 25 17 3484

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2013 035251 A (SONY CORP) 21 February 2013 (2013-02-21) | 1,7-10 | INV. H01M4/133 |
| A | * paragraphs [0026], [0027], [0031], [0056], [0057], [0061] * * figure 3 * | 2-6,13 | H01M4/134 H01M4/36 H01M4/38 H01M4/587 |
| A | CN 116 654 908 A (NINGDE AMPEREX TECHNOLOGY LTD) 29 August 2023 (2023-08-29) * claims 10,11 * * paragraphs [0141], [0143] * * figures 4,6 * | 1-15 | H01M10/0525 ADD. H01M4/02 |

**TECHNICAL FIELDS SEARCHED (IPC)**

H01M

The present search report has been drawn up for all claims

| Place of search | Date of completion of the search | Examiner |
|---|---|---|
| The Hague | 5 September 2025 | Knoflacher, Andreas |

EPO FORM 1503 03.82 (P04C01)

**EP 4 645 439 A1**

## ANNEX TO THE EUROPEAN SEARCH REPORT
## ON EUROPEAN PATENT APPLICATION NO.

EP 25 17 3484

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2025

| Patent document cited in search report | Publication date | Patent family member(s) | Publication date |
|---|---|---|---|
| JP 2013035251 A | 21-02-2013 | CN 102950771 A | 06-03-2013 |
| | | JP 2013035251 A | 21-02-2013 |
| | | US 2013209779 A1 | 15-08-2013 |
| CN 116654908 A | 29-08-2023 | CN 116654908 A | 29-08-2023 |
| | | EP 4484372 A1 | 01-01-2025 |
| | | US 2025002356 A1 | 02-01-2025 |

For more details about this annex : see Official Journal of the European Patent Office, No. 12/82

EPO FORM P0459

19

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 245332009 T